(19) Europäisches Patentamt
European Patent Office
Office européen des brevets

(11) Publication number: **0 136 443 B1**

(12) # EUROPEAN PATENT SPECIFICATION

(45) Date of publication of patent specification: **29.05.91** (51) Int. Cl.5: **G06F 11/20**

(21) Application number: **84108714.1**

(22) Date of filing: **24.07.84**

(54) **Memory correction scheme using spare arrays.**

(30) Priority: **02.09.83 US 528769**

(43) Date of publication of application:
**10.04.85 Bulletin 85/15**

(45) Publication of the grant of the patent:
**29.05.91 Bulletin 91/22**

(84) Designated Contracting States:
**DE FR GB**

(56) References cited:
**EP-A- 0 082 981**
**WO-A-83/02164**
**US-A- 3 999 051**
**US-A- 4 209 846**
**US-A- 4 375 664**

(73) Proprietor: **International Business Machines Corporation**
**Old Orchard Road**
**Armonk, N.Y. 10504(US)**

(72) Inventor: **Singh, Shanker**
**Watchill Drive**
**Fishkill, NY 12524(US)**
Inventor: **Singh, Vijendra P.**
**13179 Shadow Mountain Dr.**
**Saratoga, CA 95070(US)**

(74) Representative: **Barth, Carl Otto**
**IBM Corporation Säumerstrasse 4**
**CH-8803 Rüschlikon(CH)**

**EP 0 136 443 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

Background of the Invention

The present invention relates to correction of faulted memory using spare memory arrays.

In EP-A-95,028 entitled "Fault Alignment Control System and Circuits"; EP-A-105,402 entitled "Memory Address Permutation Apparatus"; EP-A-90,219 entitled "Memory System Restructured by Deterministic Permutation Algorithm"; and EP-A-95,669 entitled "A Method of Memory Reconfiguration for Fault Tolerant Memory", the addresses supplied to the decoders of the memory elements storing the various bit positions of a code word are skewed relative to one another when an uncorrectable error condition is detected in a code word, to change which memory cells store the faulted code word. This scheme separates stuck bits which caused the uncorrectable error, so that they will cause correctable error conditions only. For instance, if the memory was protected with a single error correcting/double error detecting code, the two cells storing the faulted bits of the code word containing a detectable error would then be placed, so that they occur in two separate code words where the faults would produce two separate correctable error conditions.

Such a scheme for separating stuck bits is suggested in the PCT Publication WO 83/02164. This publication especially relates to an apparatus for mapping and classifying the faulty bits of a large computer memory. By comparing test words read out from the memory to their original version bit errors can be detected. By counting the bit errors and relating the count to the addressing, it is possible to determine the type of fault, e.g. failures of entire bit lines or entire word lines, etc. This developed error information is used to scatter faulty memory bits among access data words.

While such relocation schemes maintain memory availability, the available memory space becomes "dirty" as a result of the accumulation of bad bits within the space as time passes. This problem is particularly acute where the failed bits are grouped in a completely bad memory chip or are the result of a plurality of bit line or word line fails. Furthermore, with address permutation schemes, when a detectable uncorrectable error is detected the whole memory has to be flushed of data while the address skewing process is being performed resulting in a significant down time for the memory.

It has been suggested that memories contain spare arrays which would be used to replace any bad bit in the memory. In one such memory, the locations of bad bits are stored separately and whenever memory access is made to an address containing an error, a bit from one of the spare arrays is substituted for the bad bit on a bit by bit basis. While this arrangement ends the accumulation of bad bits in the memory it results in significant increase in the access time of the memory. To get around this problem, it has been suggested that element substitution be done on a column or row basis as in U.S. Patent 4,051,354; U.S. Patent 3,633,175; U.S. Patent 4,038,648 and U.S. Patent 3,995,261. This involves use of whole spare rows or columns of chips which is quite an inefficient way to use spare memory capacity.

A further example for a memory system with selective assignment of spare locations is described in EP-A-82,981. This memory system uses a small writable index to store control information and replacement address information. A subset of the main memory address is applied to the index and compared with the stored addresses. In the embodiment described in the publication a minimum replacement area of 1k bit cells or of a group of four columns of a chip is suggested.

The Invention

In accordance with the present invention, as claimed, spare chips are employed together with a replacement algorithm to replace chips in a memory array when failure is generally more extensive than unrelated cell fails in the memory chips. That is, substitution will be made if an error condition is a result of the failure of a whole chip (chip-kill), a segment of a chip (island-kill), a column of bits of a chip, or a row of bits of a chip but will not be performed when it is due to a single failed cell. The replacement of a chip with a chip-kill or with an island-kill is done on the fly and involves only a row of the memory chips or elements, leaving other elements of the memory unaffected by the replacement. In the preferred embodiment, the amount of spares needed with the scheme is quite small relative to the total number of elements in the array. For instance, in one of the illustrated embodiments only two spares are needed for a matrix array of 64 x 4 memory array chips. This is because the two spare chips can be placed in any position in a column or row of the matrix of arrays.

Therefore, it is the object of the present invention to provide a sparing scheme in which memory elements are replaced in an operating machine with a zero or absolute minimum down time.

It is another object of the present invention to provide a memory element replacement scheme that requires a minimum of spare memory elements.

It is a further object of the invention to provide a memory element replacement scheme that uses a minimum of logic and a single replacement algorithm.

## The Drawings

These and other objects of the invention can best be understood by referring to the accompanying drawings of an illustrative embodiment of the invention of which:

Fig. 1 is a schematic diagram of a portion of a computer memory system incorporating the present invention;

Fig. 2 is a schematic diagram of a memory card in the memory of the computer system in Fig. 1;

Fig. 3 is a schematic drawing of a column of arrays in the memory card of Fig. 2;

Fig. 4 is a table showing the effect of various types of failures on the words in the memory;

Fig. 5 is a diagram of the test algorithm used in the memory of Fig. 1;

Fig. 6 is a diagram of a replacement algorithm used in the memory shown in Fig. 1;

Fig. 7 is an alternative form of a memory that incorporates the present invention; and

Fig. 8 is another alternative form of a memory using multi-bit array chip organization that incorporates the present invention.

## Detailed Description of the Embodiment

Fig. 1 shows a memory 32 for storing 144-bit code words or quadwords on 36 cards 10 each containing four bit positions of the code word, where 128 of the bit positions are data bits and the remainder are ECC (error correction code) check bits of a double error correction/triple error detection (DEC/TED) code. As shown in Fig. 2, all the storage bits in each bit position $B_i$ to $B_{i+3}$ of any array card 10 of the memory are arranged in a column of 64 separate 256 x 256 arrays 12 of bit storage cells, each array or chip being accessed by a separate row select line from a decoder 14 which receives a 6-bit row address and decodes it to produce an access signal on one of the 64 row access lines. This access signal selects one row of chips 12 on the card. Each of the cards 10 in Fig. 1 has a similar decode scheme, whereby a chip row address enables only one of the 64 chips in each of the 144 bit array columns of the memory.

An X-Y coordinate address of 16 bits is supplied to all of the chips 12 on the cards 10. This address is supplied to a word decoder 11 and a bit decoder 13 to select a single storage cell in each of the arrays 12. Thus, as a result of a combination of a row select address and an X-Y coordinate address a single bit in each of the 144 columns shown in Fig. 1 is selected.

This memory is a paging store, that is, data is read out of this store in pages of 256 code words each. The pages are interleaved among the arrays 12 in each column, with bits of 16 code words of a page in a given array 12. Each code word in a page has the same Y address, 1 of 16 different X addresses and of course any code word of a page may have 1 of 16 different chip row addresses.

Fig. 3 shows three of the arrays 12a, 12b and 12p for bits in the first bit position of code words. The numbers on the bits correspond to page, and word position. Thus, the left hand bit in the top most row of array 12a is numbered 1-1 since it is in the first word of the first page. The next bit position in that row is numbered 1-17 since it is in the 17th word of the first page and so on until the last or right hand bit which is numbered 16-241 to indicate it is in the 241st word of the sixteenth page. As shown, the second row of the array contains the storage cells for the first bit position of words 1, 17, 33...241 for the 17th to 32nd pages, the third line contains the storage cells for the first bit position of words 1, 17, 33...241 of the 33rd to 48th pages and so on until the 4096th page. Cells for bit positions of words 2, 18, 34...242 for pages 1 to 4096 are contained on the second chip 12b and cells for the bit positions of words 3, 19, 35...243 of pages 1 to 4096 are contained on the third chip (not shown) and so on, so that all bits in the first bit position of all code words for the first 4096 pages are contained on the top 16 chips 12a-p of the first column.

Fig. 4 shows the effect that different types of failure categories have on this memory. The first column describes the type of failure. The second column tells the number of pages affected by the type of failure listed alongside it in the first column. The third column tells how many words per page will be affected by the failures, while the fourth and fifth columns contain the word and page address patterns of the faults.

Referring back to Fig. 2, it can be seen that two spare array chips 16 are placed on each of the cards 10. Either of the spare array chips 16 can be substituted for any one of the 256 chips on the card 10. To accomplish this substitution, a 10-bit substitution address R0-R9 is stored in one of two shift register strings 20. As shall be seen, the data in each shift register string controls the substitution of one of the spares 16 for one of the arrays 12.

The first seven bits R0-R6 of the substitution address are fed into a compare circuit 22 where bit R0 operates as a compare circuit enable signal and bits R1 to R6 are compared with the chip row select address. If they match, a compare signal C is generated enabling the appropriate spare 16 so that it can be accessed through the data gating circuitry 18 in place of a bad chip. The output of the compare circuit 22 is also used to enable the one of two decoder circuits 19 which receives the other three substitution address bits R7-R9 fed into the particular shift register 20. The decode circuit selects one of the four bit or column positions $B_i$ to $B_{i+3}$ for substituting the spare array 16 for the array 12 in that column position only when the spare 16 is activated by an enabling output from the compare circuit. To accomplish the substitution the output of the decoder 19 is fed to the data gating select circuit 18 controlling the output of the particular bit position. These gating select circuits 18 operate as follows.

In each bit position $B_i$ to $B_{i+3}$ on the card 10, one output line from each of the decoders 19 is fed into an OR gate 23. So long as the given decoder output of both decoders 19 is not up, the complemented output of OR gate 23 activates an AND gate 24 to pass data to and from the chips 12 along the bit line $B_i$. When either decoder output in that bit position comes up the AND gate 24 becomes deactivated and an AND gate 26 is activated by the true of that decoder's output substituting one of the spares 16 for the disabled chip 12. Thus, it can be seen, so long as all the chips are good on the card, the address placed in either shift register 20 is all zeros, and replacement control signal C is zero preventing the decoders 19 from deselecting any chip 12 in one of the bit positions $B_i$ to $B_{i+3}$ and substituting a spare 16 therefor. When there is a non-zero output in R0 and possibly in any of the other register positions $R_1$ to $R_9$ one of the active output lines of the decoder 19 will be selected permitting the substitution.

The substitution of array chips 16 for a chip 12 is controlled by a count of the non-zero syndromes generated by the ECC logic 30 shown in Fig. 1. The ECC logic 30 receives a 144-bit code word from the memory 32 and generates error syndrome bits S1-S16 by comparing stored check bits with ECC generated check bits. A non-zero detector 36 generates an output each time the syndrome bits are not all zero and feeds this output to a counter 38. This counter is automatically reset to zero at regular time intervals. This counter 38 counts the outputs of the non-zero detector 36 between reset times and if the count exceeds a threshold count one or more times during this interval, then the counter provides a signal to the chip kill testing apparatus 40 and resets itself to zero. The testing apparatus 40 then tests the memory for a bad chip. If a completely bad chip 12 is detected, its address is sent by spare replacement logic control function 42 in the memory controller or maintenance console into one of the registers 20 of the card 10 on which the bad chip 12 is mounted to substitute a spare chip 16 for the failed chip 12. The system determines the address of the bad chip from the syndrome bits S1 to S16 of the code words or by other code words in the error pattern of Fig. 4 which update the counter.

If the test does not turn up a completely bad chip it will not cause the substitution. Instead, it allows the faulty but still viable chip 12 to remain in the memory until the computer system containing the memory goes into diagnostic mode for some other reason. Then a complete diagnostic analysis of the whole memory system is performed and the locations of bad bit lines or word lines are detected and the spares are used to substitute for faulty chips, giving the highest priority for chip-kills causing UEs (uncorrectable errors), followed by island-kills and line-kills respectively. Because of the periodic resetting of the counter 38 it is unlikely that chips containing individual cell fails or line fails will invoke the test procedure because the count in the counter will never reach the count of the threshold level before the counter is cleared. Therefore, only when there is a chip with a chip-kill or island-kill type of fault, the test procedure is performed.

A better understanding of the test procedure can be obtained from the flow diagram of Fig. 5. As shown, when the non-zero syndrome counter 38 indicates the number of non-zero syndromes has exceeded the threshold level, the page and word address $P_j$ $A_i$ of the addressed word containg the bad bit is stored and the bit location is generated by the bad bit locator 44 and also stored, in step 45. The next step 46 is to test the memory for killed chips. This is done by generating syndromes for words $P_jA_{(i+16)}$ and $P_{(j+16)}A_i$. As can be seen from Fig. 3, the bit locations of words $P_jA_{(i+16)}$ and $P_{(j+16)}$ $A_i$ are located on the same chip adjacent to the failed bit in $P_jA_i$ on a common bit or word line with the failed bit. The assumption being made in the test is that if two bits on the same line are bad the line is bad and if both the tested word line and bit line are bad the chip is all bad. The testing is done by placing test words into the memory and generating the syndromes from those test words.

1. From the first 16 quadwords in page $P_j$ determine the quadword address $A_i$ containing the stuck bit. As pointed out above, the error correcting code syndrome will identify the bit position. Note the word address Ai. From PjAi and bit position identify the faulty chip location.

2. Identify the possible stuck bit position in memory word $PjA_{i+16}$ or $PjA_{i+32}$ by noting the error syndrome bits from the ECC apparatus. Also identify the possible stuck bit position for word $A_i$ in page $P_{j+16}$.

3. Test for identical bit stuck positions by comparing error syndrome bits from these words and determine the fault type as shown in the flow diagram in Fig. 5:

(a) Identical stuck bit positions in words PjAi, $PjA_{i+16}$ and $P_{j+16}Ai$ implies chipkill.

(b) Identical stuck bit positions in words PjAi, $PjA_{i+16}$ but not in $P_{j+16}Ai$ implies a word linekill.

(c) Identical stuck bit position in word PjAi and $P_{j+16}Ai$ but not in $PjA_{i+16}$ implies bit linekill.

(d) Stuck bit position in PjAi alone implies a cell fail.

Further verification of an already identified fault type is always possible by randomly selecting and testing for same stuck bit positions as shown in (a), (b), (c), and (d) on words such as $PjA_{i+32}$, $PjA_{i+48}$...; and, $P_{j+32}Ai$, $P_{j+48}Ai$...respectively. It is noted in Fig. 4 that the occurrence of a chipkill affects $\frac{1}{4}$ of BSM (basic storage module) in the memory, i.e. 4K pages out the 16K pages provided in a BSM.

If, in the replacement algorithm a chipkill pattern is found by step 56 of Fig. 6, the chip is replaced on the fly and the syndrome counter 38 is reset in step 60. If a chipkill is not found, the counter continues to count and automatically resets at a regular time interval. If the threshold is not exceeded again, normal operation is continued without substitution. If the threshold is exceeded in step 62, the page Pj is deallocated and normal operation is continued. The page is also deallocated when an uncorrectable error (UE) is detected by the ECC apparatus and normal operation is resumed. As explained previously, the next time the machine goes into diagnostic mode, all or some spare chips can be assigned in such a way so that UEs and correctable errors in the memory BSM are minimized.

Above has been described one embodiment of the invention. This embodiment is of a paging store. However, as shown in EP Application No. of same priority date herewith and entitled "Reconfigurable Memory Using Both Address Permutation and Spare Memory Elements", the invention is not limited to backing stores with certain modifications. This sparing technique can be used in combination with address permutation apparatus in small main stores, or in combination with double complement apparatus using the same testing algorithm. However the testing algorithm is a function of memory organization. Before the testing techniques described herein can be used, the location of bits indicating chip kills or bits indicating word and bit line failures must be identified in the memory under consideration.

Another memory using the same testing algorithm is shown in Fig. 7. Here the placement of the two spares 16 can be made into any one of the 144 chips on the card where each chip contains one bit $B_i$ of the code word. Such card organization is selected for obtaining high data rate from the BSM. A substitution is made when either select bit S1 or S2 is non-zero, activating one of the decoders. Then the bit position replacement address bits $R_1$ to $R_8$ in the particular shift register specifies which array is to be replaced. The decoders, data gating and shift registers operate in the manner described in connection with the previously described embodiment to accomplish the substitution.

A third embodiment of card design is shown in Fig. 8 where multibit chips of 256K bit each are organized as 64 x 2 chip array. This also uses one or two spare arrays per card. The ECC code with this embodiment is single error correct/single package detect. Upon the detection of a 2-4 bit package error the spare is substituted for defective arrays, while single bit errors in BSM are corrected by the single bit error correction capability of the code.

Above have been described three embodiments of the invention. It should be apparent that the invention is adaptable to varying memory configurations. The unit of replacement can also be multi-chip array modules on a card or complete array cards in a BSM. Such card and module replacements may be necessary in some cases to overcome a support logic fail. Also, the designer can choose to make replacements offline after each memory diagnostic step for simplification.

## Claims

**1.** A computer system having a memory (32) protected by an error checking arrangement (30, 36, 44) in which data is stored in multi-bit position code words with different bit positions on different arrays (12),

with spare array substitution means (16, 18, 20, 42) for substituting a spare array (16) for a faulty array (12), characterized by:

counter means (38) for counting the number of occurrences of non-zero syndrome signals of a syndrome generator (30) of said error checking arrangement (36), said counter means being reset to zero at regular time intervals or upon reaching a threshold count,

test means (40) for testing the memory for bad arrays by means of said error checking arrangement when the count in the counter exceeds that threshold count; and

spare replacement logic means (42) controlled by said test means and by error location logic means (44) of said error checking arrangement.

2. The system of claim 1 wherein said error checking arrangement is an error detection and correction system, and

said threshold count is in excess of that likely to be caused by single cell failures in that arrays during that time interval but will be exceeded by and thus detect multiple failures of entire row and column type in a single array.

3. The system of claim 2 wherein said test means (40) checks for multiple failures of row and column type and said spare replacement logic means (42) effects that substitution only when said test means detects a multiple row and column failure.

4. The system of claim 1 wherein the bit positions of a code word are contained in a plurality of memory cards (10), each containing a number of arrays, and wherein each card comprises a small number of spare arrays (16) and for each said spare is provided a separate register (20) for storing an array substitution address, and a compare circuit (22) for comparing said stored substitution address with the corresponding part of the current array address and for issueing a spare array enabling signal (C) when the compared array addresses match.

5. The system of claim 4 wherein each card (10) further comprises a decoder circuit (19) for each said spare (16), said decoder being enabled by said spare array enabling signal (C) from said compare circuit (22) to decode a number of low order array address bits (R7, R8) also stored in said register (20) and to select one of a plurality of data bit input/output gates (18) adapted to substitute data bits to/from said spare array (16) for data bits to/from said memory array (12) which is being replaced.

6. The system of a previous claim including means (42) for substituting spare arrays for arrays with at least a single row or column failure when said arrays are not being used to substitute for a bad array.

7. In a computer system having a memory protected by an error checking arrangement, in which data is stored in multibit code words with different bit positions on different arrays, the method comprising:

counting during periodic time intervals of the operating time of the memory the number of occurrences of correctable errors detected by the error checking arrangement,

testing (52-56, 45, 46) the memory for bad arrays by means of the syndrome signals generated by said error checking arrangement (30, 36, 44) when the count of said occurences exceeds a predetermined number in excess of those likely to be caused by unrelated single bit failures, and

substituting (60, 66) a spare array for an array that the tests indicate contains failures other than unrelated single bit failures leaving those arrays containing unrelated stuck bits in the memory.

8. The method of claim 7 wherein the replacement of arrays categorized as chip fails is effected (60) on-the-fly upon completion of the testing but arrays categorized as bit line fails or word line fails are replaced (66) at a later time when the memory goes into the next diagnostic mode, based on the available bits of spare arrays at that time.

9. The method of claim 7 wherein said counting is done offline during memory diagnostics to detect the type of memory fault.

## Revendications

1. Système informatique comportant une mémoire (32) protégée par un agencement de vérification d'erreur (30,36,44), dans laquelle des données sont stockées dans des mots de code à positions binaires multiples avec des positions de bit différentes sur des matrices différentes (12), avec des moyens de substitution de matrice de réserve (16,18,20,42) pour substituer une matrice de réserve (16) à une matrice défectueuse (12), caractérisé par :
des moyens de comptage (38) pour compter le nombre d'apparitions de signaux de syndrome non zéro fournis par un générateur de syndrome (30) dudit agencement de vérification d'erreur (36), lesdits moyens de comptage étant remis à zéro à intervalles de temps réguliers ou lorsqu'ils atteignent un compte de seuil ;
des moyens d'essai (40) pour essayer la mémoire en ce qui concerne des matrices défectueuses, au moyen dudit agencement de vérification d'erreur, lorsque le compte dans le compteur dépasse ce compte de seuil ; et
des moyens logiques de remplacement de matrice de réserve (42) commandés par lesdits moyens d'essai et par des moyens logiques de localisation d'erreur (44) du dit agencement de vérification d'erreur.

2. Système suivant la revendication 1,dans lequel ledit agencement de vérification d'erreur est un système de détection et de correction d'erreur, et
ledit compte de seuil est supérieur au compte probablement engendré par des défaillances de cellule unique dans ces matrices pendant cet intervalle de temps mais il est dépassé par des défaillances multiples du type à rangée entière et colonne entière dans une matrice unique et il détecte donc ce type de défaillances.

3. Système suivant la revendication 2, dans lequel lesdits moyens d'essai (40) recherchent les défaillances multiples du type rangée et colonne, et lesdits moyens logiques de remplacement de réserve (42) effectuent cette substitution seulement lorsque lesdits moyens d'essai détectent une défaillance multiple de rangée et de colonne.

4. Système suivant la revendication 1, dans lequel les positions de bit d'un mot de code sont contenues dans une pluralité de cartes de mémoire (10), contenant chacune une pluralité de matrices, et dans lequel chaque carte comprend un petit nombre de matrices de réserve (16) et, pour chaquedite matrice de réserve, il est prévu un registre séparé (20), pour stocker une adresse de substitution de matrice, et un circuit de comparaison (22) pour comparer ladite adresse de substitution stockée avec la partie correspondante de l'adresse de matrice existante et pour émettre un signal d'activation de matrice de réserve (C) lorsque les adresses de matrice comparées concordent.

5. Système suivant la revendication 4, dans lequel chaque carte (10) comprend en outre un circuit décodeur (19) pour chaque dite matrice de réserve (16), le dit décodeur étant activé par ledit signal d'activation de matrice de réserve (C) venant dudit circuit de comparaison (22) pour décoder un certain nombre de bits d'adresse de matrice de poids faible (R7,R8) également stockés dans ledit registre (20) et pour sélectionner une d'une pluralité de portes (18) d'entrée/sortie de bit de données prévues pour substituer des bits de données, vers/à partir de ladite matrice de réserve (16), aux bits de données vers/à partir de ladite matrice de mémoire (12) qui est à remplacer.

6. Système suivant l'une quelconque des revendications précédentes, comprenant des moyens (42) pour substituer les matrices de réserve à des matrices comportant au moins une défaillance de rangée ou colonne unique lorsque lesdites matrices ne sont pas utilisées pour remplacer une matrice défectueuse.

7. Dans un système informatique comprenant une mémoire protégée par un agencement de vérification d'erreur,dans laquelle des données sont stockées en mots de code multibits avec des positions de bit différentes sur des matrices différentes , la méthode comprenant :
le comptage, pendant des intervalles de temps périodiques du temps de fonctionnement de la mémoire, du nombre d'apparitions d'erreurs corrigibles détectées par l'agencement de vérification d'erreur ;
l'essai (52-56,45,46) de la mémoire pour rechercher les matrices défectueuses, au moyen des signaux de syndrome fournis par ledit agencement de vérification d'erreur (30,36,44), lorsque le compte desdites apparitions dépasse un nombre prédéterminé supérieur aux apparitions qui sont probablement engendrées par des défaillances de bit unique sans relation ; et
la substitution (60,66) d'une matrice de réserve à une matrice dont les essais indiquent qu'elle contient des défaillances autres que des défaillances de bit unique sans relation, les matrices contenant des bits bloqués sans relation étant laissées dans la mémoire.

8. Méthode suivant la revendication 7, dans laquelle le remplacement des matrices classées comme ayant des défaillances de puce est effectué (60) au vol à la fin de l'essai, mais les matrices classées comme ayant des défaillances de ligne de bit ou des défaillances de ligne de mot sont remplacées (66) plus tard lorque la mémoire passe en mode de diagnostic suivant, sur la base des bits disponibles des matrices de réserve à ce moment.

9. Méthode suivant la revendication 7, dans laquelle ledit comptage est effectué en différé, pendant le diagnostic de la mémoire, pour détecter le type de défaut de mémoire.

**Ansprüche**

1. Computersystem mit einem durch eine Fehlerprüfanordnung (30, 36, 44) geschützten Speicher (32), in den Daten als Codewörter mit mehreren Bitstellen gespeichert werden, wobei verschiedene Bitstellen sich auf verschiedenen Matrizen (12) befinden,

mit einer Substitutionsvorrichtung (16, 18, 20, 42) zum Substituieren einer fehlerhaften Matrix (12) durch eine Ersatzmatrix (16) gekennzeichnet durch:

eine Zählvorrichtung (38) zum Zählen der Häufigkeit des Auftretens von von null verschiedenen Syndromsignalen eines Syndromgenerators (30) der Fehlerprüfanordnung (36), wobei die Zählvorrichtung in regulären Zeitintervallen oder beim Erreichen eines Schwellwertes auf null rückgestellt wird,

eine Prüfvorrichtung (40) zum Prüfen des Speichers auf schlechte Matrizen mittels der Fehlerprüfanordnung, wenn der Zählerstand des Zählers den Schwellwert überschreitet und

eine Logikvorrichtung (42) für das Ersetzen durch Ersatzteile, die durch die Prüfvorrichtung und durch die Fehlerlokalisationsvorrichtung (44) der Fehlerprüfanordnung gesteuert wird.

2. System nach Anspruch 1, bei dem die Fehlerprüfanordnung ein Fehlererkennungs-/ und -korrektursystem ist und in dem der Schwellwert denjenigen überschreitet, der wahrscheinlich während des Zeitintervalls durch einzelne Zellausfälle verursacht wird, aber der überschritten wird durch und daher erkennt mehrfache Ausfälle von der Art einer ganzen Zeile und Spalte in einer einzigen Matrix.

3. System nach Anspruch 2, bei dem die Prüfvorrichtung (40) auf mehrfache Ausfälle von der Art einer Zeile und Spalte prüft und die Logikvorrichtung (42) zum Ersetzen durch Ersatzteile diese Substitution nur bewirkt, wenn die Prüfvorrichtung einen mehrfachen Zeilen- und Spaltenausfall erkennt.

4. System nach Anspruch 1, bei dem die Bitstellen eines Codewortes in einer Mehrzahl von Speicherkarten (10) enthalten sind, von denen jede eine Anzahl von Matrizen enthält und bei dem jede Karte eine kleine Anzahl von Ersatzmatrizen (16) umfaßt und für jede der Ersatzmatrizen ist ein separates Register (20) zum Speichern einer Adresse für eine Matrixsubstitution vorgesehen, und eine Vergleichsschaltung (22) zum Vergleich der gespeicherten Substitutionsadresse mit dem entsprechenden Teil der laufenden Matrixadresse und zum Ausgeben eines Aktivierungssignales (C) für die Ersatzmatrix wenn die verglichenen Matrixadressen übereinstimmen.

5. System nach Anspruch 4, in dem jede Karte (10) weiter eine Decodierschaltung (19) enthält für jede Ersatzmatrix (16) wobei die Decodierschaltung durch das aus der Vergleichsschaltung (22) stammende Aktivierungssignal (C) für die Ersatzmatrix aktiviert wird, um eine Reihe von wertniedrigeren Adressenbits der Matrix (R7, R8), die auch in dem Register (20) gespeichert sind, zu decodieren und um eine aus einer Mehrzahl von Datenbiteingangs-/ Ausgangsverknüpfungsgliedern (18) auszuwählen, die geeignet ist, Datenbits für die oder aus der Ersatzmatrix (16) gegen Datenbits für die oder von der Speichermatrix (12), die ersetzt wird, zu substituieren.

6. System nach einem vorhergehenden Anspruch, das eine Vorrichtung (42) einschließt zum Substituieren von Matrizen mit zumindest einem Ausfall einer einzelnen Zeile oder Spalte durch Ersatzmatrizen, wenn diese nicht zur Substitution einer schlechten Matrix benutzt werden.

7. In einem Computersystem, das einen durch eine Fehlerprüfanordnung geschützten Speicher besitzt, in dem Daten gespeichert werden in mehrstelligen Codewörtern, wobei verschiedene Bitstellen sich auf verschiedenen Matrizen befinden, das Verfahren enthaltend:

Zählen während periodischer Zeitintervalle der Betriebszeit des Speichers die Häufigkeit des Auftretens korrigierbarer Fehler, die durch die Fehlerprüfanordnung erkannt wurden

Prüfen (52-56, 45, 46) des Speichers auf schlechte Matrizen mittels der Syndromsignale, die durch eine Fehlerprüfanordnung (30, 36, 44) erzeugt wurden, wenn das Zählergebnis des Auftretens eine vorgegebene Zahl überschreitet, die größer ist als diejenige, die wahrscheinlich von unverbundenen Einzelbitausfällen verursacht wird

und

Substituieren (60, 66) einer Matrix, von der die Prüfungen anzeigen, daß sie andere als unverbundene Einzelbitausfälle enthält, durch eine Ersatzmatrix und Belassen der Matrizen, die unverbundene fehlerhafte Bits enthalten im Speicher.

**8.** Verfahren nach Anspruch 7, bei dem das Ersetzen der Matrizen, die klassifiziert wurden als Chip fällt aus unmittelbar nach Beenden des Prüfens bewirkt wird (60), aber Matrizen, die klassifiziert wurden als Bitleitung fällt aus oder Wortleitung fällt aus werden ersetzt (66) zu einem späteren Zeitpunkt, wenn der Speicher in den nächsten Diagnosemodus geht, basierend auf den verfügbaren Bits der Ersatzmatrizen zu jenem Zeitpunkt.

**9.** Verfahren nach Anspruch 7, bei dem das Zählen vom System getrennt während der Speicherdiagnose erfolgt, um die Art des Speicherfehlers zu erkennen.

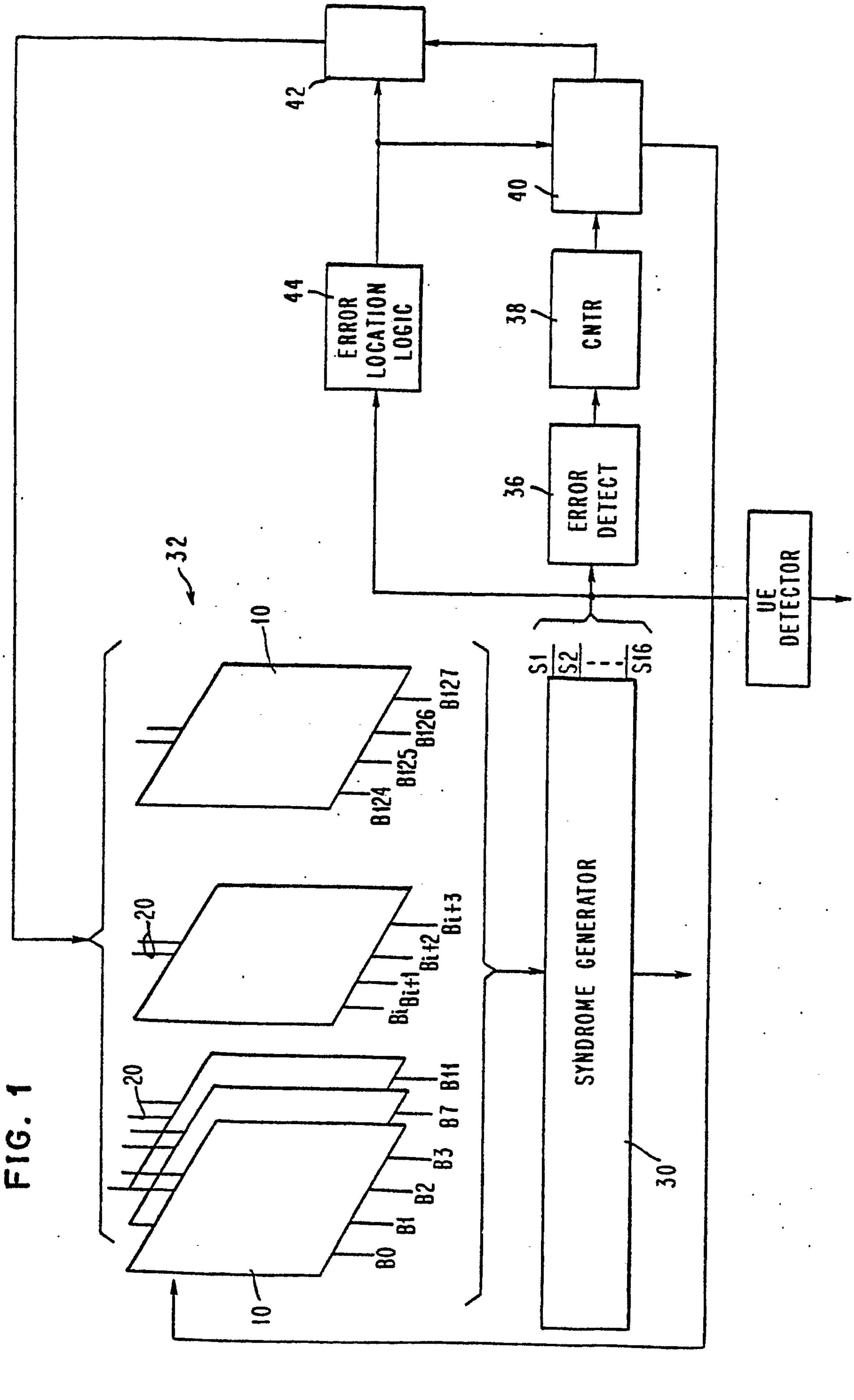
32
10
20
B0
B1
B2
B3
B7
B11
Bi
Bi+1
Bi+2
Bi+3
B124
B125
B126
B127
SYNDROME GENERATOR
30
S1
S2
S16
ERROR DETECT
36
CNTR
38
40
42
ERROR LOCATION LOGIC
44
UE DETECTOR

FIG. 1

FIG. 2

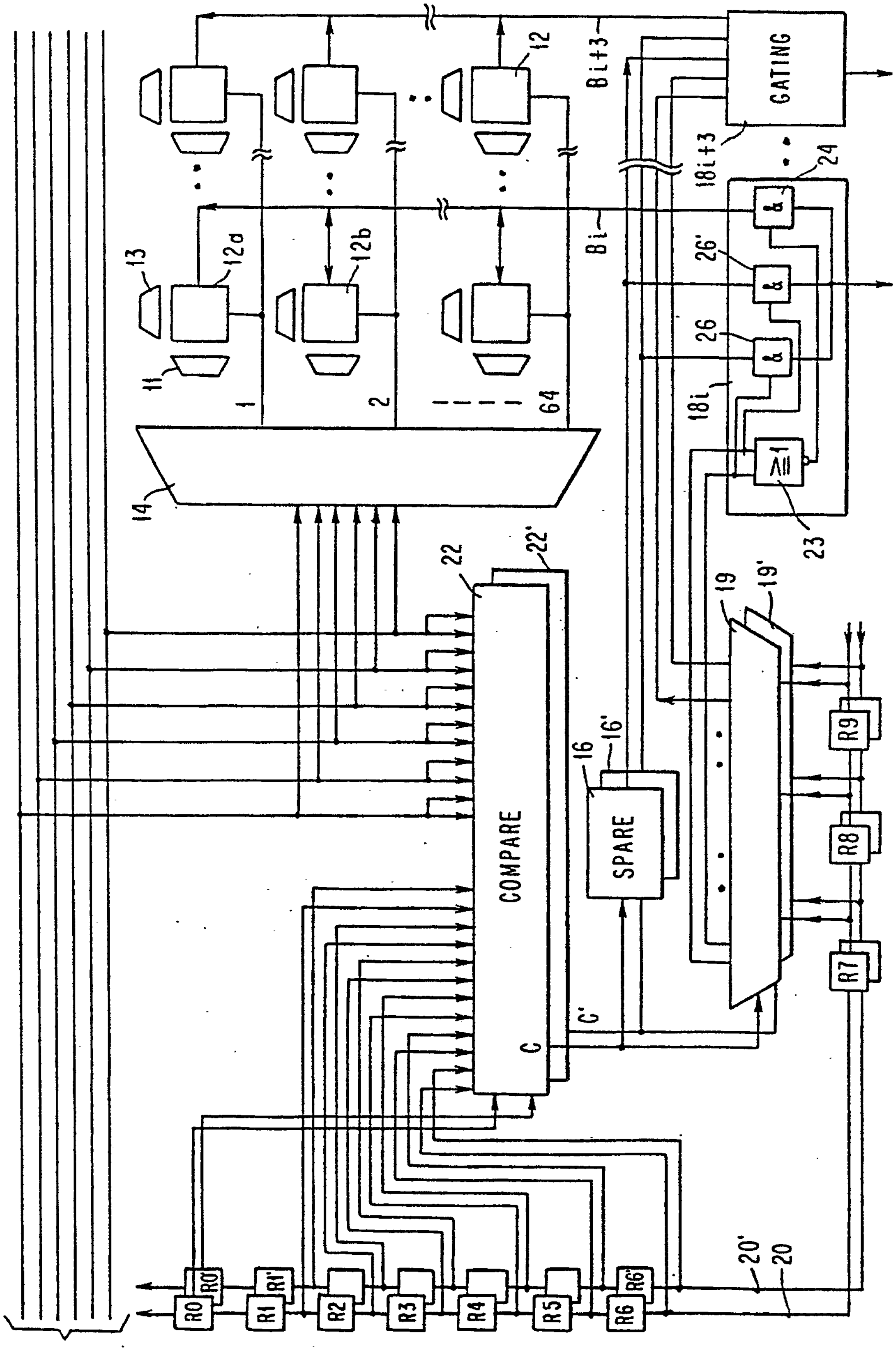
COMPARE
SPARE
GATING
R0
R1
R2
R3
R4
R5
R6
R7
R8
R9
Bi
Bi+3
18i
18i+3
C
C'
&
≥1
11
12
12a
12b
13
14
16
16'
19
19'
20
20'
22
22'
23
24
26
26'
1
2
64

FIG. 3

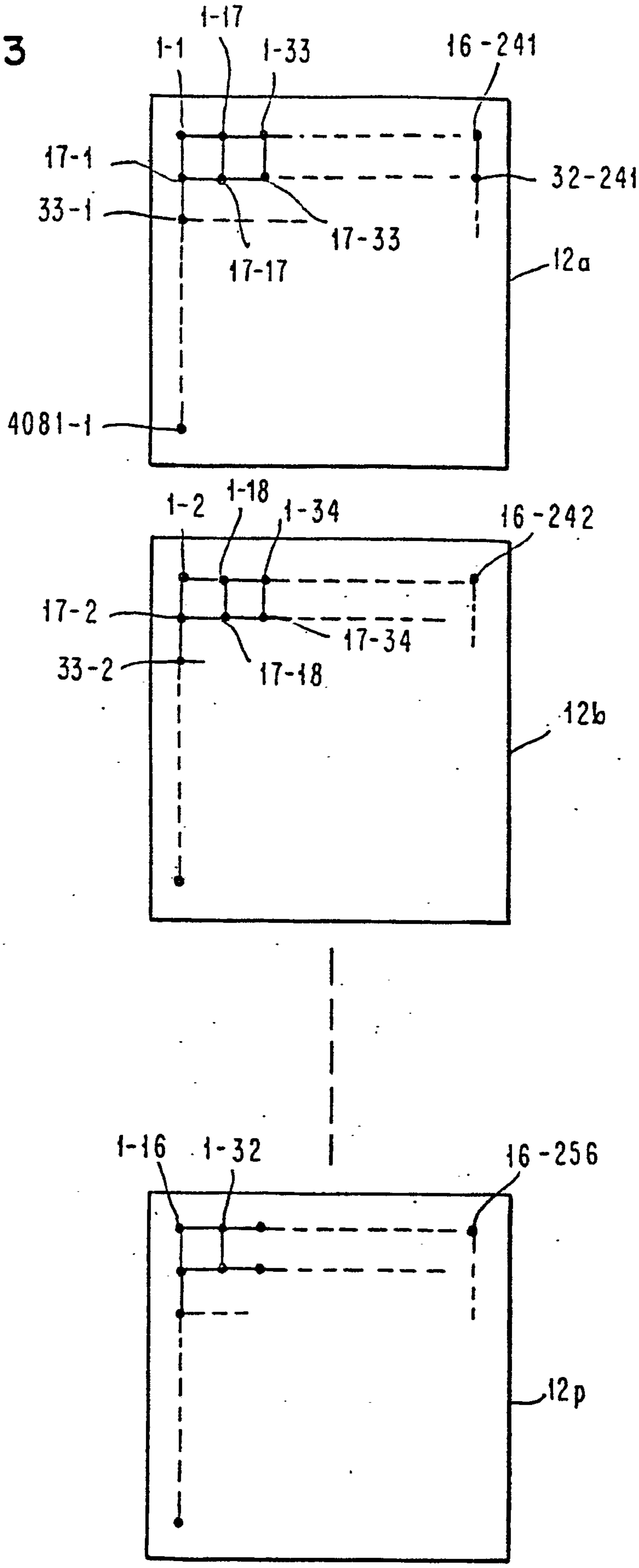
1-17
1-1
1-33
16-241
17-1
32-241
33-1
17-33
17-17
12a
4081-1
1-2
1-18
1-34
16-242
17-2
17-34
33-2
17-18
12b
1-16
1-32
16-256
12p

FIG. 4

| FAULTS | # OF PAGES | # OF ECC WRD / PAGE | WORD PATTERN ERROR LENGTH & MUTUAL DISTANCE | PAGE PATTERN |
|---|---|---|---|---|
| CELL | 1 | 1 | 1; ADDRESS ai | 1; PAGE ADDR. pj |
| BIT LINE | 256 | 1 | 1; ADDRESS ai | 256; pj, pj+16, pj+32... |
| WORD LINE | 16 | 16 | 16; ADDRESS ai, ai+16, ai+32... | 16; pj, pj+1, pj+2... |
| CHIPKILL | 4K (1/4BSM) | 16 | SAME AS WORD LINE | 4K; pj, pj+1, pj+2... |

FIG. 5

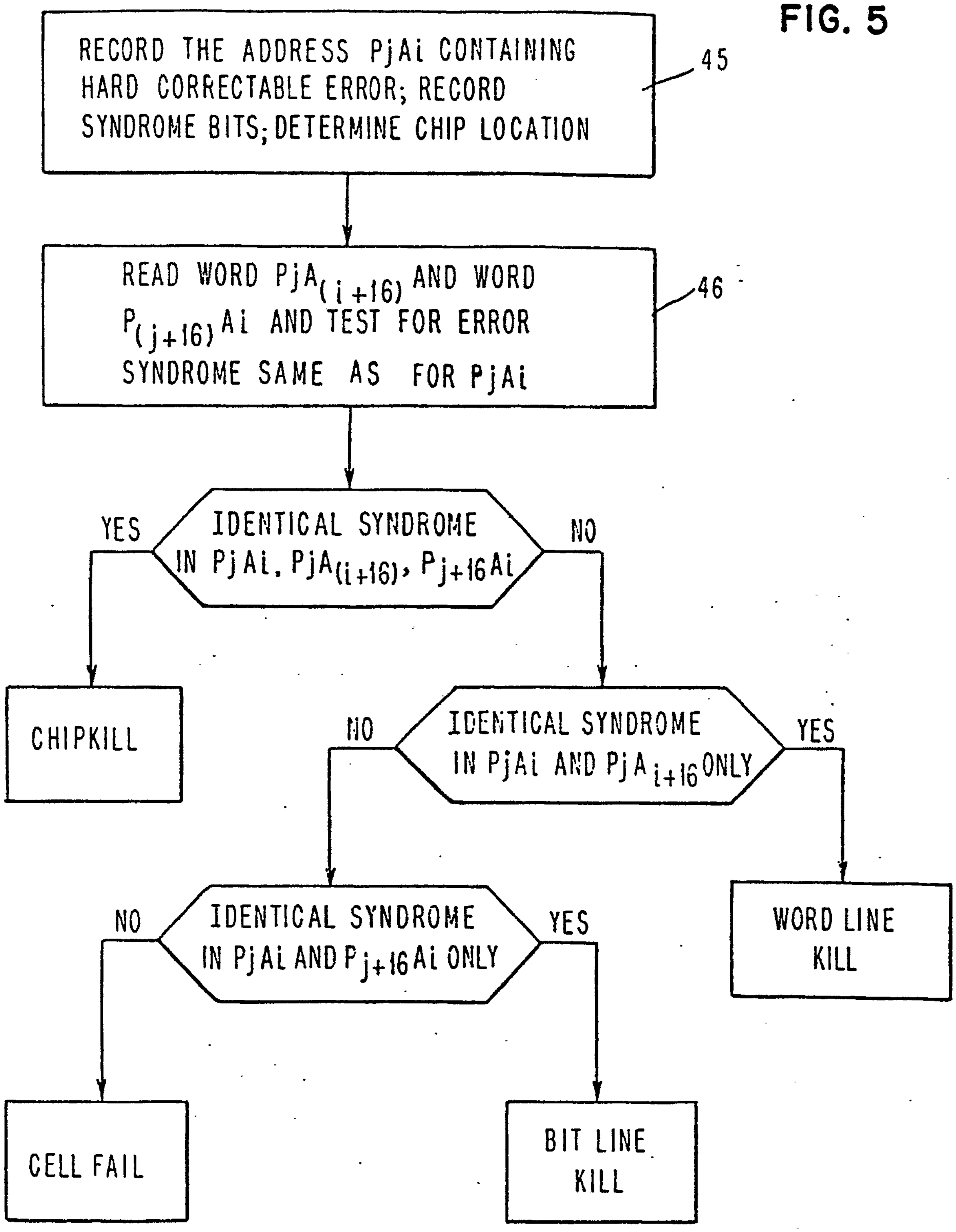
RECORD THE ADDRESS PjAi CONTAINING HARD CORRECTABLE ERROR; RECORD SYNDROME BITS; DETERMINE CHIP LOCATION
45
READ WORD PjA(i+16) AND WORD P(j+16)Ai AND TEST FOR ERROR SYNDROME SAME AS FOR PjAi
46
IDENTICAL SYNDROME IN PjAi, PjA(i+16), Pj+16Ai
YES
NO
CHIPKILL
IDENTICAL SYNDROME IN PjAi AND PjAi+16 ONLY
NO
YES
WORD LINE KILL
IDENTICAL SYNDROME IN PjAi AND Pj+16Ai ONLY
NO
YES
CELL FAIL
BIT LINE KILL

FIG. 6

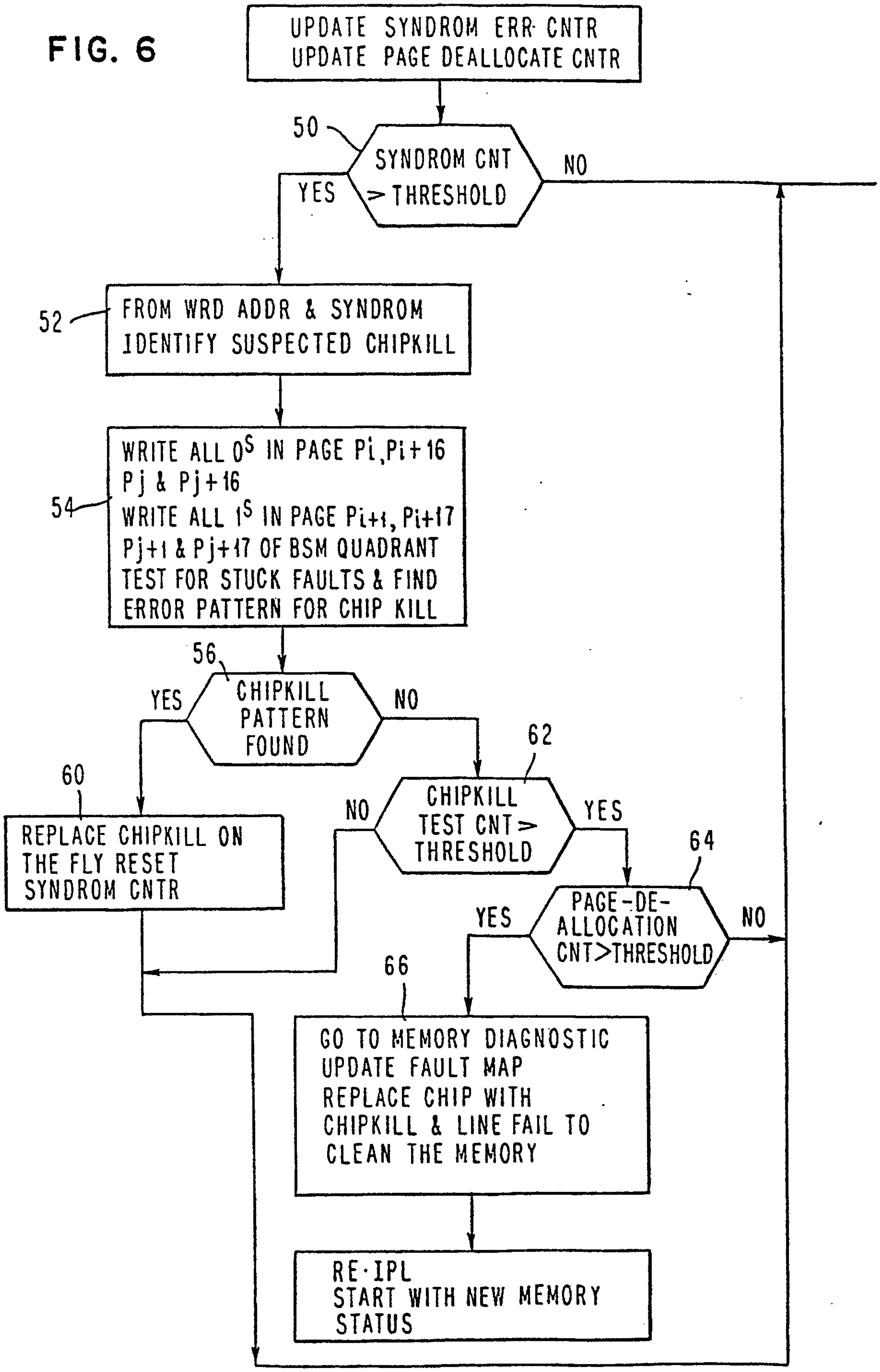
UPDATE SYNDROM ERR CNTR
UPDATE PAGE DEALLOCATE CNTR
50
SYNDROM CNT > THRESHOLD
YES
NO
52
FROM WRD ADDR & SYNDROM IDENTIFY SUSPECTED CHIPKILL
54
WRITE ALL 0S IN PAGE Pi,Pi+16 Pj & Pj+16
WRITE ALL 1S IN PAGE Pi+1, Pi+17 Pj+1 & Pj+17 OF BSM QUADRANT
TEST FOR STUCK FAULTS & FIND ERROR PATTERN FOR CHIP KILL
56
CHIPKILL PATTERN FOUND
YES
NO
60
REPLACE CHIPKILL ON THE FLY RESET SYNDROM CNTR
62
CHIPKILL TEST CNT > THRESHOLD
NO
YES
64
PAGE-DE-ALLOCATION CNT>THRESHOLD
YES
NO
66
GO TO MEMORY DIAGNOSTIC
UPDATE FAULT MAP
REPLACE CHIP WITH CHIPKILL & LINE FAIL TO CLEAN THE MEMORY
RE-IPL
START WITH NEW MEMORY STATUS

FIG. 7

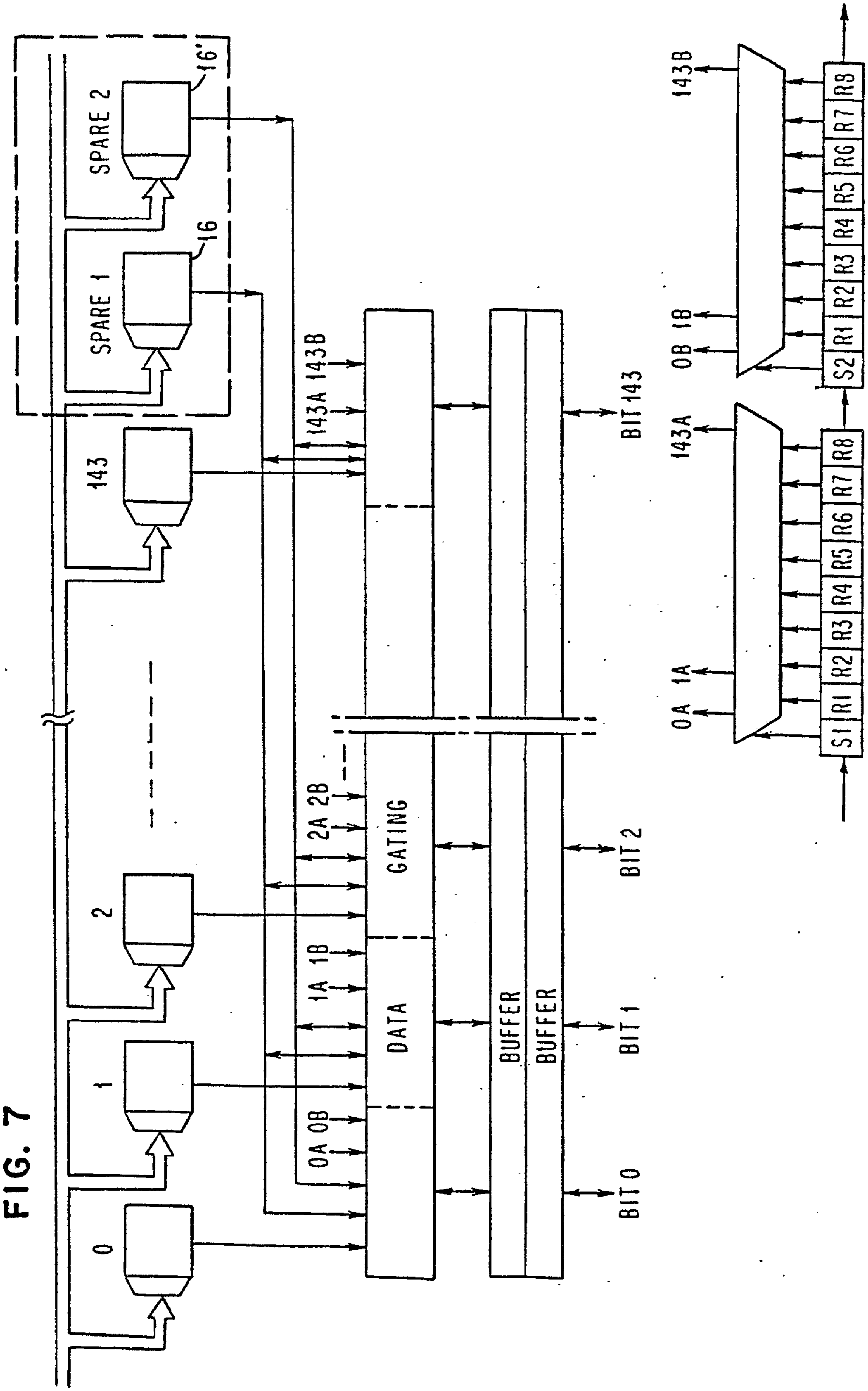
SPARE 2
16'
SPARE 1
16
143
2
1
0
0A 0B
1A 1B
2A 2B
143A 143B
DATA
GATING
BUFFER
BUFFER
BIT 0
BIT 1
BIT 2
BIT 143
0A 1A
143A
0B 1B
143B
S1 R1 R2 R3 R4 R5 R6 R7 R8
S2 R1 R2 R3 R4 R5 R6 R7 R8

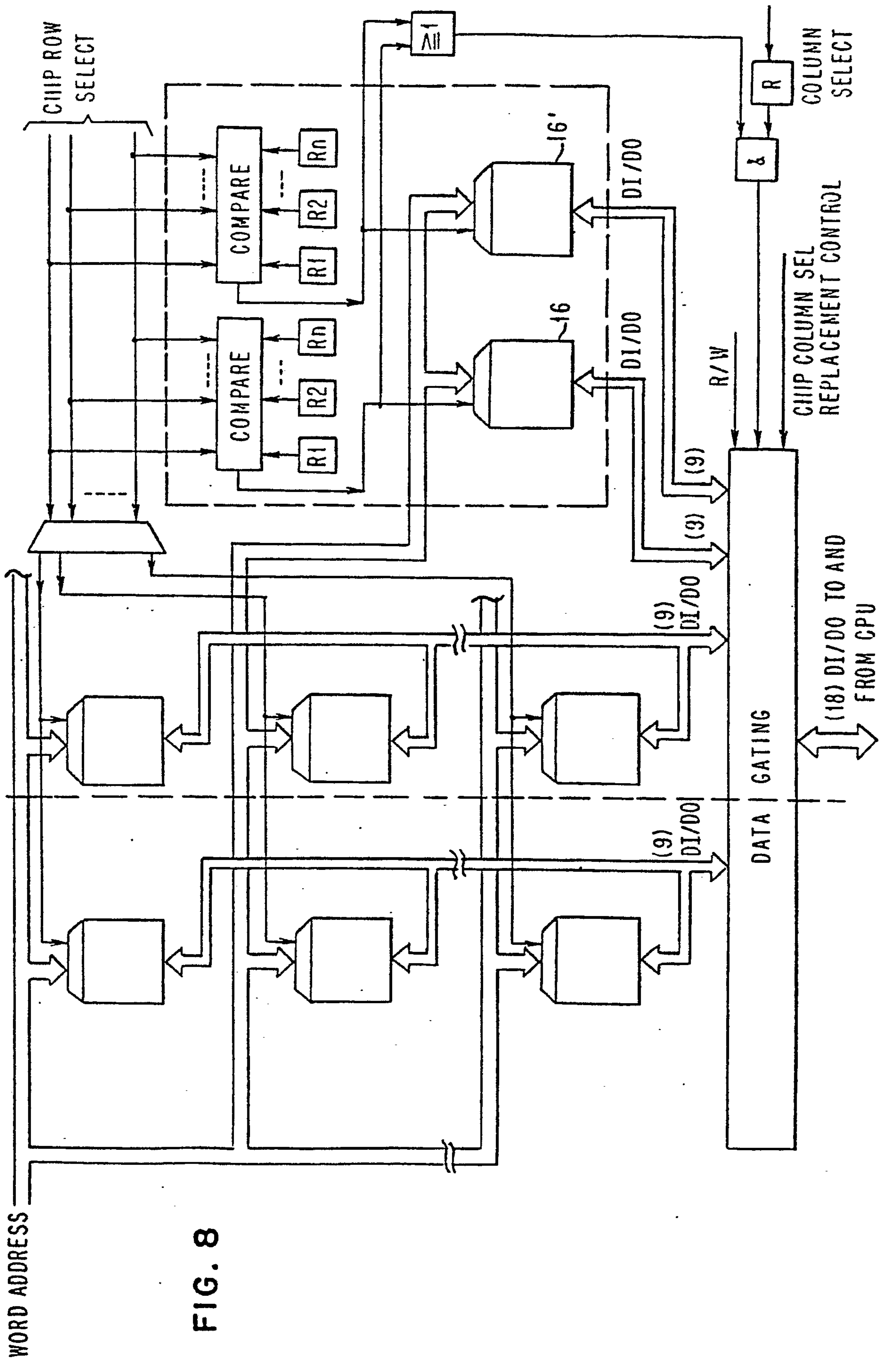
CHIP ROW SELECT
COMPARE
COMPARE
R1
R2
Rn
R1
R2
Rn
≥1
R
&
COLUMN SELECT
16'
16
DI/DO
DI/DO
R/W
CHIP COLUMN SEL
REPLACEMENT CONTROL
(9)
(9)
(9) DI/DO
(9) DI/DO
DATA GATING
(18) DI/DO TO AND FROM CPU
WORD ADDRESS

FIG. 8